# DEMANDE DE BREVET EUROPEEN

(11) **EP 2 236 353 A1**
(43) Date de publication de la demande: **06.10.2010**
(21) Numéro de dépôt: 10155584.5
(22) Date de dépôt: 05.03.2010
(51) Int. Cl.: B60P 3/20, B62D 33/04, H01L 31/052

(54) **Panneau ventilé et véhicule épquipé d'un tel panneau**

(30) Priorité: 02.04.2009 FR 0952117
(71) Demandeur: Photowatt International S.A., 38300 Bourgoin-Jallieu (FR)
(72) Inventeur: Aurousseau, Valery, 38110, St Clair de la Tour (FR); Dumas, Philippe, 38890, Saint Chef (FR)
(74) Mandataire: Maureau, Philippe

(57) **Abrégé**

L'invention a pour objet un panneau (1) destiné à former une partie d'une paroi (10a) délimitant une enceinte réfrigérée d'un caisson réfrigéré (10) ou à être disposé sur une telle paroi (10a), le panneau (1) comprenant un module photovoltaïque (2) comportant au moins une cellule photovoltaïque sur la face du panneau (1) tournée vers l'extérieur du caisson (10), une couche de matériau isolant (4) sur la face du panneau (1) tournée vers l'intérieur du caisson (10), et des moyens de circulation d'air (3), interposés entre le module photovoltaïque (2) et ladite couche d'isolant (4) ainsi qu'un caisson réfrigéré (10) comportant sur une de ses parois (10a) un tel panneau (1) et un véhicule (11) comportant un tel caisson (10).

## Description

La présente invention concerne un panneau destiné à former une partie d'une paroi délimitant une enceinte réfrigérée d'un caisson réfrigéré ou à être disposé sur une telle paroi.

Les circuits de distributions utilisent des camions munis de caissons réfrigérés pour assurer le transport de marchandises.

Ces caissons embarqués sont constitués de panneaux plans offrant de grandes surfaces soumises au rayonnement solaire conduisant à un échauffement du caisson.

Il est donc souhaitable d'améliorer la performance énergétique de tels caissons.

A cet effet, la présente invention a pour objet un panneau destiné à former une partie d'une paroi délimitant une enceinte réfrigérée d'un caisson réfrigéré ou à être disposé sur une telle paroi, le panneau comprenant un module photovoltaïque comportant au moins une cellule photovoltaïque sur la face du panneau tournée vers l'extérieur du caisson, une couche de matériau isolant sur la face du panneau tournée vers l'intérieur du caisson, et des moyens de circulation d'air, interposés entre le module photovoltaïque et ladite couche d'isolant.

La présente invention permet de tirer profit de la surface des enceintes réfrigérées pour y installer un champ photovoltaïque permettant de produire une partie de l'énergie nécessaire au refroidissement de celle-ci, tout au long des périodes de jour ainsi que de profiter d'un mouvement relatif d'un véhicule au vent sur lequel le panneau est installé pour refroidir les modules photovoltaïques et limiter leur échauffement sous l'effet de l'irradiation solaire.

Les moyens de circulation d'air, comme une prise d'air à l'avant dans le sens de circulation permettent d'améliorer les performances aérauliques du panneau. De manière générale, ce panneau pourra être associé à des accessoires aérauliques en entrée et en sortie des conduits des moyens de circulation d'air.

Ce panneau trouve son application dans les caissons frigorifiques embarqués des camions frigorifique et permet d'utiliser l'énergie électrique générée par le système photovoltaïque directement au refroidissement de l'intérieur du caisson tout en profitant du déplacement d'air relatif au déplacement du camion pour refroidir le système photovoltaïque et constitué un gradient thermique isolant entre le système photovoltaïque et le panneau isolant qui reste ainsi à des températures moins chaudes que s'il était soumis directement à l'irradiation solaire.

Selon un mode de réalisation, la couche isolante est constituée par une paroi isolante d'origine du caisson.

Cette disposition permet d'adapter le panneau aux parois d'origines existantes et permet ainsi de faire diminuer le coût du panneau ainsi que son poids. Cela permet également d'élaborer des panneaux sur mesure pour profiter pleinement de l'ensemble de la surface disponible sur la paroi du caisson.

Selon un autre mode de réalisation, des cadres latéraux de fixation avec rupture de pont thermique sont agencés pour maintenir le système photovoltaïque.

Cette disposition permet de limiter d'éventuels apports de chaleur à travers les éléments de fixation des modules photovoltaïque ainsi que de faciliter le montage sur la structure du caisson frigorifique et l'intégration des connectiques électriques.

Selon un mode de réalisation, un convertisseur et des batteries de stockage sont reliées au système photovoltaïque.

Cette disposition permet de stocker l'énergie issue du système photovoltaïque pour la restituer par la suite au groupe froid et en particulier à son compresseur chargé de produire du froid à l'intérieur du caisson.

Selon un mode de réalisation, le système photovoltaïque comprend des parties en matériau polymère transparent.

Cette disposition permet d'alléger le système photovoltaïque afin de réduire la consommation en carburant du camion.

L'invention a également pour objet un caisson réfrigéré comportant une paroi délimitant une enceinte réfrigérée, et au moins un panneau tel que décrit précédemment faisant partie de ladite paroi ou disposé sur ladite paroi.

Mais également un véhicule comprenant un tel caisson réfrigéré ainsi qu'un véhicule dont un panneau est disposé sur la face supérieure et/ou les faces latérales du caisson.

La disposition consistant à intégrer un panneau photovoltaïque sur les faces latérales du caisson du véhicule vise à profiter au maximum des parois disponibles du véhicule.

Cependant, les faces latérales du caisson ayant généralement une moins bonne exposition aux irradiations solaires que la face supérieure, et l'une de ces faces latérales présentant généralement un taux d'ensoleillement supérieur à l'autre durant la journée, il peut être envisagé d'utiliser pour les faces latérales des panneaux photovoltaïques en matériaux amorphes qui malgré leur rendement plus faible sont moins chers que les panneaux photovoltaïques cristallins qui eux équiperont la face supérieure.

L'invention porte encore sur un véhicule dont les moyens de circulation d'air comprennent au moins une prise d'air dans le sens de circulation normal du véhicule mais aussi sur un véhicule dont les moyens de circulation d'air comprennent des prises d'air intermédiaires.

De toute façon, l'invention sera bien comprise à l'aide de la description qui suit, en référence aux dessins schématiques annexés, représentant à titre d'exemple non limitatif, un mode de réalisation et d'utilisation du panneau selon l'invention.

La figure 1 est une coupe transversale d'un panneau selon l'invention.

La figure 2 est une coupe transversale illustrant le montage de deux panneaux sur un caisson selon l'invention.

La figure 3 est une coupe transversale d'un caisson réfrigéré selon l'invention.

La figure 4 illustre un véhicule et en particulier un camion frigorifique équipé d'un caisson avec un panneau selon l'invention.

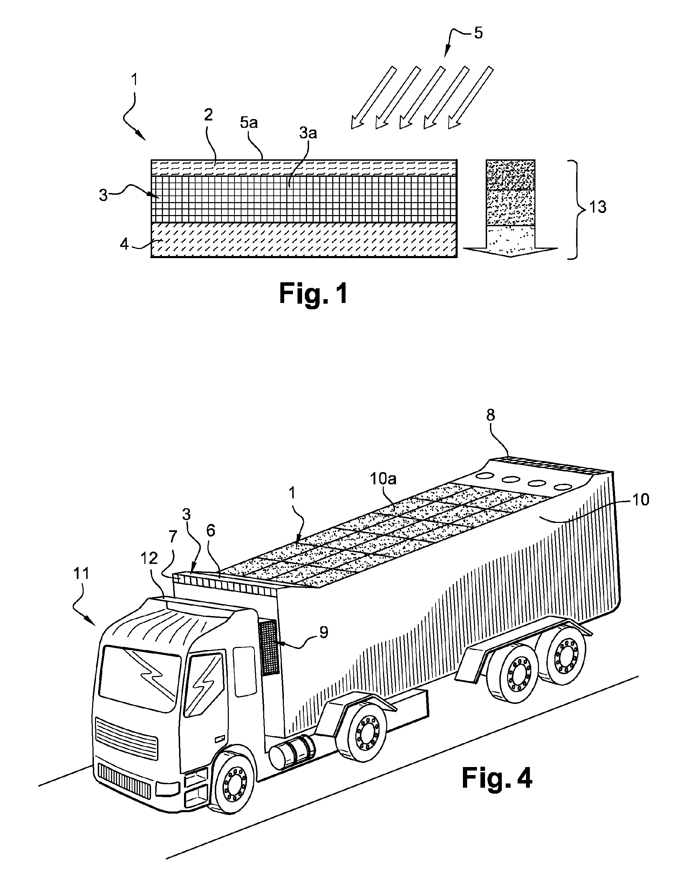

Comme nous le montre la figure 1, un panneau 1 selon l'invention comporte un module photovoltaïque 2 et une couche de matériau isolant 4 entre lesquels sont agencés des moyens de circulation d'air 3 comprenant un caisson de ventilation 3a.

Le module photovoltaïque 2 présente une surface 5a dirigée vers le haut, exposée aux radiations solaires 5. Cette surface 5a est réalisée en matériau polymère transparent afin de diminuer le poids du panneau 1 tout en conservant la propriété de transparente conférée habituellement sur ce type de panneau par une couche de verre.

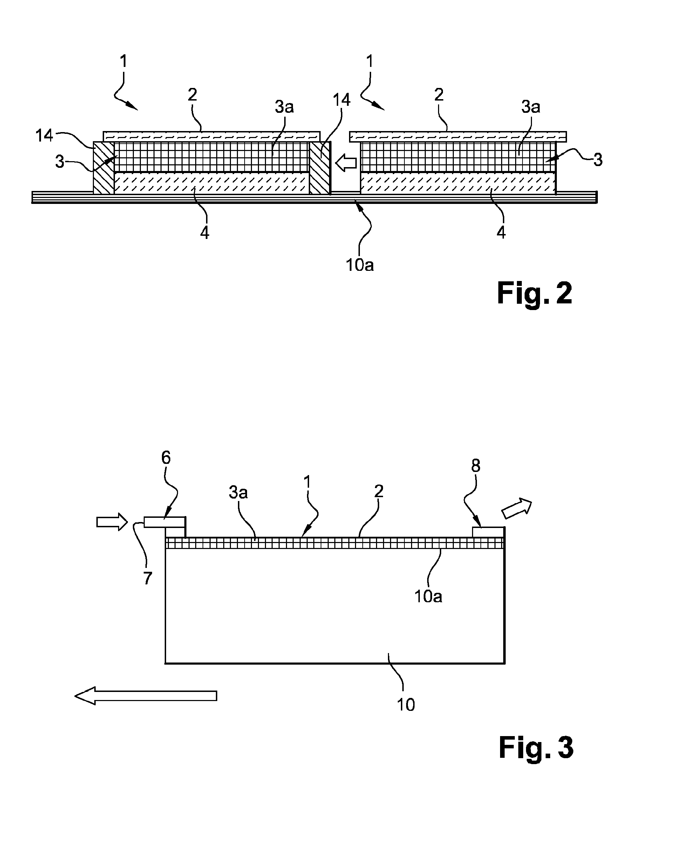

La couche de matériau isolant 4 peut idéalement être constituée par une paroi d'origine du caisson tel qu'illustré à la figure 3 mais peut également se superposer à celle-ci comme cela est montré à la figure 2.

Sur cette figure 2, on peut voir deux panneaux 1 disposés directement sur la structure d'un caisson frigorifique 10.

Pour faciliter le montage, des cadres latéraux 14 sont disposés sur le caisson 10 afin de soutenir deux bords opposés d'un premier panneau 1. Le panneau et en particulier sa partie la plus lourde : le module photovoltaïque, ne porte que sur une moitié de la largeur de la face haute du cadre latéral 14 servant au support du panneau 1. L'autre moitié est utilisée pour supporter le bord d'un second panneau 1 venant ainsi se raccorder au premier. Un cadre latéral 14 est ainsi utilisé pour le support de deux panneaux 1 adjacents.

Ces cadres latéraux 14 sont conçus pour réaliser une rupture de pont thermique entre la partie module photovoltaïque 2 du panneau 1 qu'ils supportent et le caisson frigorifique 10 sur lequel ils reposent.

Cette rupture thermique est réalisée par l'utilisation d'un matériau à faible conductivité thermique tel le plastique, disposé à la mi-hauteur des éléments de support 14 et sur toute leur épaisseur, qui relie deux parties des éléments de support. Le réchauffement de la surface haute 10a du caisson frigorifique 10 par conduction thermique à travers ces éléments de support 14 est ainsi fortement diminué.

De plus, ces cadres latéraux 14 présentent une configuration et un agencement permettant leur utilisation pour intégrer la connectique électrique issue des modules photovoltaïques 2.

Les moyens de circulation d'air 3 avec son caisson de ventilation 3a se trouvant sous le module photovoltaïque 2 sont traversés par l'air ambiant qui contribue d'une part au refroidissement du module photovoltaïque 2 et d'autre part à l'isolation thermique de la paroi du caisson 10 sur lequel le panneau 1 est installé.

Afin d'augmenter les échanges thermiques et pour augmenter le gradient thermique entre le module photovoltaïque 2 et la couche d'isolant 4 du caisson 10, l'intérieur du caisson de ventilation 3a présente plusieurs ailettes agencées dans une configuration en nid d'abeille.

La paroi du caisson 10 étant plus froide que la paroi du module photovoltaïque 2 exposée aux radiations solaires 5, il est maintenu suivant la hauteur du panneau 1 un gradient thermique 13 tel qu'illustré à la figure 1.

Selon la figure 3, une prise d'air 6 est disposée à l'avant du caisson frigorifique 10 et une sortie d'air 8 à l'arrière de ce même caisson 10.

Cette prise d'air 6 capte à travers une entrée d'air 7 de l'air ambiant pour le faire circuler à travers le caisson de ventilation 3a situé sous le module photovoltaïque 2 réchauffé par les radiations solaires 5. Cet air emmagasine ainsi des calories qu'il évacue du panneau 1 à travers la sortie d'air 8 disposée à l'arrière du caisson 10.

De manière générale, cette circulation d'air peut être associée à des accessoires aérodynamiques en entrée et sortie du caisson de ventilation 3a afin d'améliore les performances aérauliques du panneau 1.

Sur de très longs caissons 10, il peut être envisagé des prises d'air 6 intermédiaires pour éviter une surchauffe de l'air passant dans le caisson de ventilation 3a et garantir ainsi la performance du panneau sur toute la surface équipée.

Ce panneau trouve son application sur des véhicules 11 disposant de surfaces assez étendues pour être propices à l'installation de ce type de panneau 1, comme illustré à la figure 4.

En particulier, la surface haute 10a de la remorque d'un camion semi-remorque frigorifique 11 nécessitant un surplus d'énergie électrique afin d'alimenter les compresseurs nécessaires à la production du froid refroidissant son caisson frigorifique 10, présente des dispositions idéales à l'installation de ce type de panneau 1.

En effet, en période d'ensoleillement, le système photovoltaïque 2 contribue à recharger les batteries délivrant l'énergie nécessaire à l'alimentation du compresseur du groupe froid 9.

Le refroidissement du module photovoltaïque 2 par les moyens de circulation d'air 3 sera d'autant plus important que le camion 11 est en mouvement.

En effet, le vent relatif engendré par les mouvements du camion 11 est conditionné à l'intérieur du caisson de ventilation 3a par la prise d'air 6 disposée à l'avant du caisson frigorifique 10 dans le sens du mouvement du camion 11.

Afin de permettre une circulation d'air dans le système de ventilation, une sortie d'air 8 est disposée à l'arrière du caisson frigorifique 10.

De plus, pour améliorer l'aérodynamisme du camion 11 ainsi qu'augmenter le flux d'air pénétrant par la prise d'air 7, des spoilers 12 sont agencés sur la cabine du camion 11.

Selon une variante, un ou plusieurs panneaux photovoltaïques selon l'invention sont disposés sur les faces latérales du caisson du véhicule.

Il peut être envisagé d'utiliser pour les faces latérales des panneaux photovoltaïques en matériaux amorphes.

Comme il va de soi, l'invention ne se limite pas à la forme de réalisation préférentielle décrite ci-dessus, à titre d'exemple non-limitatif ; elle en embrasse au contraire toutes les variantes.

## Revendications

1. Panneau (1) destiné à former une partie d'une paroi délimitant une enceinte réfrigérée d'un caisson réfrigéré (10) ou à être disposé sur une telle paroi (10a), le panneau (1) comprenant :
- un module photovoltaïque (2) comportant au moins une cellule photovoltaïque sur la face (5a) du panneau (1) tournée vers l'extérieur du caisson (10),
- une couche de matériau isolant (4) sur la face du panneau (1) tournée vers l'intérieur du caisson (10), et
- des moyens de circulation d'air (3), interposés entre le module photovoltaïque (2) et ladite couche d'isolant (4).

2. Panneau (1) selon la revendication 1 dans lequel la couche isolante (4) est constituée par une paroi isolante (10a) d'origine du caisson (10).

3. Panneau (1) selon l'une des revendications précédentes dans lequel des cadres latéraux (14) de fixation avec rupture de pont thermique sont agencés pour maintenir en position le module photovoltaïque (2) sur la paroi (10a) du caisson (10).

4. Panneau (1) selon l'une des revendications précédentes dans lequel un convertisseur et des batteries de stockage sont reliées au module photovoltaïque (2).

5. Panneau (1) selon l'une des revendications précédentes dans lequel le module photovoltaïque (2) comprend des parties en matériau polymère transparent.

6. Caisson réfrigéré (10) comportant une paroi (10a) délimitant une enceinte réfrigérée, et au moins un panneau (1) faisant partie de ladite paroi (10a) ou disposé sur ladite paroi (10a) selon l'une des revendications 1 à 5.

7. Véhicule (11) comprenant un caisson réfrigéré (10) selon la revendication 6.

8. Véhicule (11) selon la revendication 7, dans lequel le panneau (1) est disposé sur la face supérieure (10a) du caisson (10).

9. Véhicule (11) selon l'une des revendications 7 ou 8, dans lequel un panneau (1) est disposé sur une face latérale du caisson (10).

10. Véhicule (11) selon l'une des revendications 7 à 9, dans lequel les moyens de circulation d'air (3) comprennent au moins une prise d'air (6) dans le sens de circulation normal du véhicule (11).

11. Véhicule (11) selon la revendication 10 dans lequel les moyens de circulation d'air (3) comprennent des prises d'air intermédiaires.
